# EUROPEAN PATENT APPLICATION

(11) **EP 4 722 800 A1**
(43) Date of publication of application: **08.04.2026**
(21) Application number: 25191757.1
(22) Date of filing: 25.07.2025
(51) Int. Cl.: G02F 1/1345, H05K 3/321

(54) **DISPLAY DEVICE AND ELECTRONIC DEVICE INCLUDING THE SAME**

(30) Priority: 04.10.2024 KR 20240134861
(71) Applicant: Samsung Display Co., Ltd., Yongin-si, Gyeonggi-do 17113 (KR)
(72) Inventor: KO, Hyunseok, 17113 Giheung-Gu, Yongin-si, Gyeonggi-Do (KR)
(74) Representative: Dr. Weitzel & Partner

(57) **Abstract**

Provided is a display device including a display panel, a circuit board electrically coupled to the display panel, and an adhesive layer between the display panel and the circuit board. The display panel includes a base substrate including a display region and a non-display region adjacent to the display region, a driving chip mounted on the non-display region, and a plurality of display pads on the non-display region, and electrically coupled to the driving chip and the circuit board. The driving chip may be provided in an opening defined in the adhesive layer, and a thickness of the driving chip may be smaller than a thickness of the adhesive layer.

## Description

The present invention relates to a display device.

Multimedia apparatuses (e.g., electronic devices) such as a television, a mobile phone, a tablet computer, a navigation unit, and a game console include a display device which generates an image and which displays an image to a user through a display screen. The display device may include a display panel to display an image, and a circuit board coupled to the display panel to provide an electrical signal.

The present invention provide a display device in which a space occupied by a circuit board is reduced. The invention is defined by the features of the independent claims. The dependent claims and the description provide preferred embodiments.

An embodiment of the present invention provides a display device including a display panel, a circuit board electrically coupled to the display panel, and an adhesive layer between the display panel and the circuit board, wherein the display panel includes a base substrate including a display region and a non-display region adjacent to the display region, a driving chip mounted on the non-display region, and a plurality of display pads on the non-display region and electrically coupled to the driving chip and the circuit board, and the driving chip is provided in an opening defined in the adhesive layer and a thickness of the driving chip is smaller than a thickness of the adhesive layer. In an embodiment, an electronic device includes the display device.

In an embodiment of the present invention, a display device includes a display panel, an adhesive layer on a top surface of the display panel, and having an opening defined therein, and a circuit board on a top surface of the adhesive layer and electrically coupled to the display panel, wherein the display panel includes a base substrate including a display region and a non-display region that is adjacent to the display region and that is bent with respect to a bending axis that extends in a first direction, and a driving chip mounted on the non-display region and provided in the opening, a thickness of the adhesive layer and a thickness of the driving chip are different from each other, and when viewed on a plane (e.g., viewed in a plan view), the driving chip does not overlap the adhesive layer.

When the adhesive layer is double sided, that means it sticks at the display panel and the circuit board (with a substance-to-substance connection), it may prevent moisture and other foreign substances from penetrating into the hole where the driving chip is placed.

The accompanying drawings are included to provide a further understanding of the present invention, and are incorporated in and constitute a part of this specification. The drawings illustrate embodiments of the present invention and, together with the description, serve to explain principles of embodiments of the present invention. In the drawings:
FIG. 1 is a perspective view of a display device according to an embodiment of the present invention;
FIG. 2 is an exploded perspective view of the display device illustrated in FIG. 1;
FIG. 3 is a plan view illustrating some components of the display device illustrated in FIG. 2;
FIG. 4 is an enlarged plan view illustrating a portion of a display panel and a circuit board illustrated in FIG. 3;
FIG. 5 is a cross-sectional view of a display module according to an embodiment of the present invention;
FIG. 6A is a cross-sectional view of a display panel, a circuit board, an adhesive layer, and a conductive adhesive layer, taken along line I-I' illustrated in FIG. 3;
FIG. 6B is a cross-sectional view of a bending region illustrated in FIG. 6A in a bent state;
FIG. 7 is a cross-sectional view of a display device according to a Comparative Example;
FIG. 8 is a cross-sectional view of a display device according to a Comparative Example; and
FIG. 9 is a cross-sectional view of a display panel and a circuit board, taken along line II-II' illustrated in FIG. 3.

In this specification, it will be understood that when an element (or a region, a layer, a portion, and/or the like) is referred to as being "on", "connected to" or "coupled to" another element, it may be directly on, connected to, or coupled to the other element, or other elements may be therebetween.

Like reference numerals or symbols refer to like elements throughout. In the drawings, the thickness, ratio, and size of the elements may be exaggerated to effectively describe the technical contents. As used herein, the term "and/or" includes any and all combinations of one or more of the associated listed elements.

It will be understood that, although the terms "first", "second", and/or the like, may be used herein to describe various elements, the elements are not to be limited by these terms. These terms are only used to distinguish one element from another element. For instance, a first element discussed below could be termed a second element without departing from the scope of the present invention. Similarly, a second element could be termed a first element. In this specification, the singular expressions "a", "an" and "the" are intended to include the plural forms as well, unless the context clearly indicates otherwise.

In embodiments, the terms "below", "under", "on the lower side", "above", "over", "on the upper side", and/or the like may be used to describe the relationships between the elements illustrated in the drawings. These terms are relative concepts and are described on the basis of the directions indicated in the drawings.

It will be further understood that the terms "comprises, includes, has" and/or "comprising, including, having", when used in this specification, specify the presence of stated features, numbers, steps, operations, elements, components or combinations thereof, but do not preclude the possibility of the presence or addition of one or more other features, numbers, steps, operations, elements, components, and/or combinations thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the present invention are described with reference to the drawings.

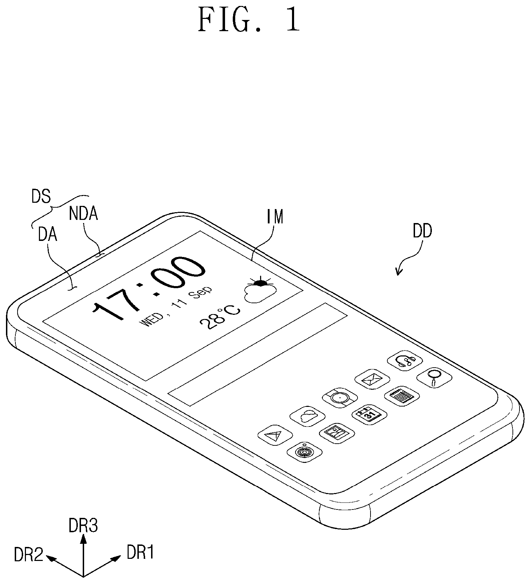

FIG. 1 is a perspective view of a display device DD according to an embodiment of the present invention.

Referring to FIG. 1, the display device DD may be activated in response to an electrical signal and may display an image IM. For example, the display device DD may be a large-sized device (e.g., an electronic device) such as a television and/or an outdoor billboard, as well as a small- or medium-sized device such as a monitor, a mobile phone, a tablet computer, a navigation unit, and/or a game console. However, embodiments of the display device DD are provided as examples, and the display device DD is not limited to any of these embodiments. In this embodiment, the display device DD is illustrated as a mobile phone as an example.

The display device DD may be rigid or flexible. The term "flexible" may indicate a bendable property, and may include all structures from a structure which is completely foldable to a structure which is bendable to the level of several nanometers. For example, a flexible display device DD may include a curved device, a slidable device, a rollable device, and/or a foldable device.

The display device DD may have, on a plane, a rectangular shape having short sides that extend in a first direction DR1 and long sides that extend in a second direction DR2 that crosses the first direction DR1. However, the display device DD is not limited thereto, and may have, on a plane, various suitable shapes such as a circular shape or a polygonal shape that is not a quadrilateral shape.

In this embodiment, a third direction DR3 may be defined as a direction perpendicular (e.g., substantially perpendicular) to a plane defined by the first direction DR1 and the second direction DR2. A front surface (or a top surface) and a rear surface (or a bottom surface) of each of the members constituting the display device DD may be opposed to each other (e.g., may face each other) in the third direction DR3, and normal directions of a front surface and a rear surface may be substantially parallel to the third direction DR3, respectively. A distance between a front surface and a rear surface is defined along the third direction DR3 and may correspond to a thickness of a member.

In this specification, the wording "on a plane" may be defined as a state seen from the third direction DR3. In this specification, the wording "on a cross section" may be defined as a state seen from the first direction DR1 or the second direction DR2. Directions indicated by the first to third directions DR1, DR2, and DR3 are relative concepts, and may thus be changed to other directions.

The display device DD may display an image IM through a display surface DS. The display surface DS may correspond to a front surface of the display device DD. The display surface DS of the display device DD may include a plane defined by the first direction DR1 and the second direction DR2, and may display the image IM in the third direction DR3 crossing the plane. The display surface DS is not limited thereto, and may further include a curved surface bent from at least one side of the plane.

The display surface DS of the display device DD may include a display part DA and a non-display part NDA. The display part DA may be a region in which the image IM is displayed within the display surface DS. The image IM may be displayed through the display part DA in the third direction DR3. The image IM may include a dynamic image as well as a static image, and a clock and icons are illustrated in FIG. 1 as an example of the image IM.

The non-display part NDA may be a region which is adjacent to the display part DA and in which the image IM is not displayed within the display surface DS. The non-display part NDA may have a lower light transmittance than the display part DA. In an embodiment, the non-display part NDA may surround the display part DA, and may define the shape of the display part DA. However, the non-display part NDA is not limited thereto, and may be only on one side of the display part DA or may be omitted.

The display device DD according to an embodiment may sense an external input applied from the outside. The external input may include various suitable types (or kinds) of inputs. For example, the external input may include force, pressure, temperature, light, and/or the like. The external input may include not only an input touches the display device DD (for example, a touch by a user's hand and/or a pen), but also an input applied proximate to the display device DD (for example, that hovers over the display device DD).

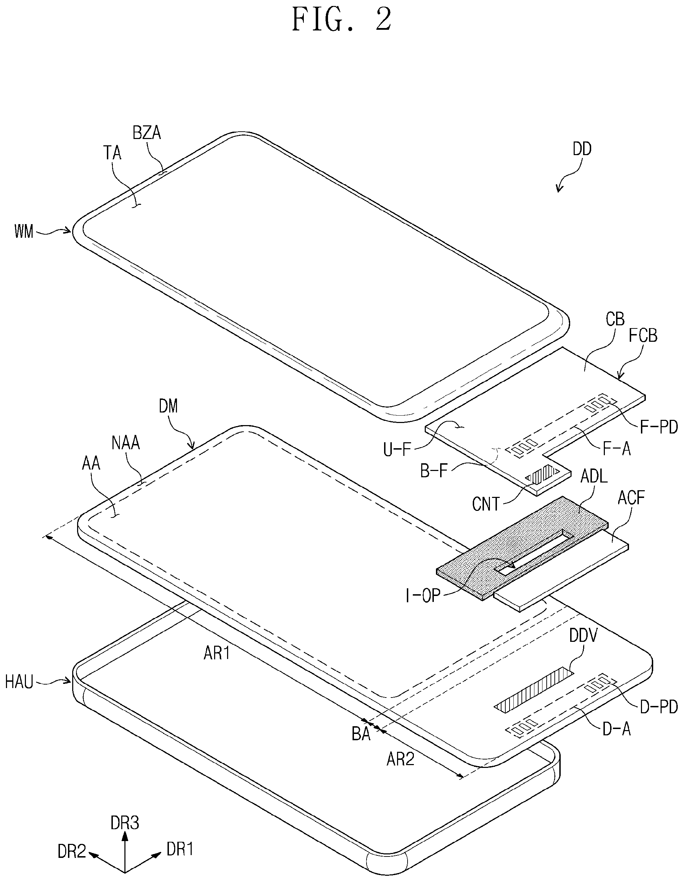

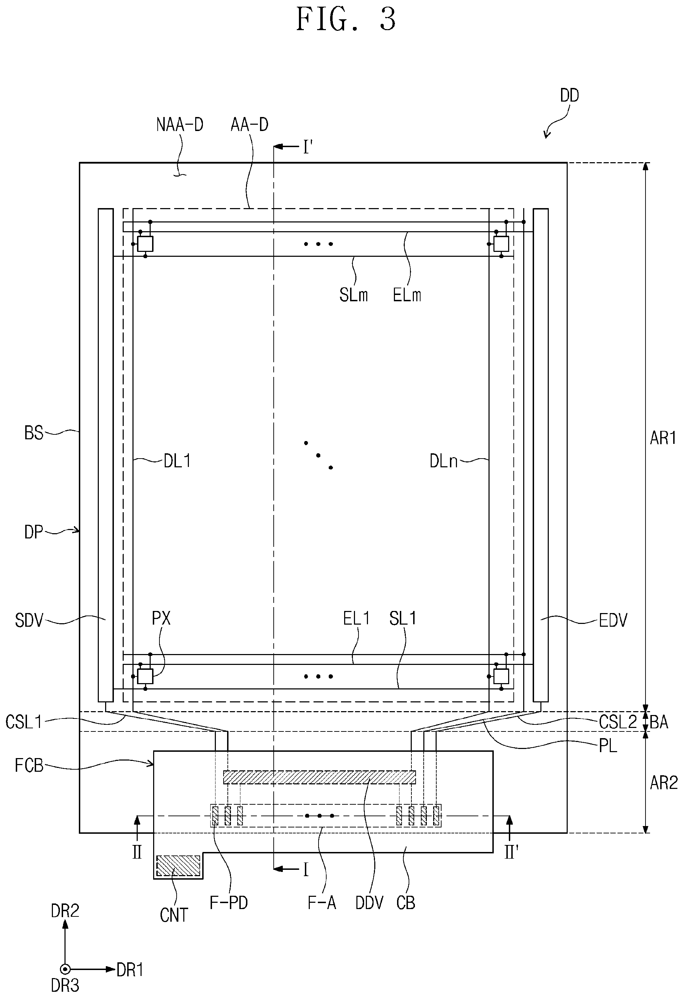

FIG. 2 is an exploded perspective view of the display device DD illustrated in FIG. 1. FIG. 3 is a plan view illustrating some components of the display device DD illustrated in FIG. 2.

As an example, in FIG. 3, a driving chip DDV is illustrated in a dotted line.

Referring to FIG. 2, the display device DD may include a window WM, a display module DM, a circuit board FCB, an adhesive layer ADL, a conductive adhesive layer ACF (e.g., an electrically conductive layer), and a housing HAU. However, the components of the display device DD are not limited to the embodiments illustrated herein and may further include a functional layer such as an anti-reflection layer between the display module DM and the window WM, and/or an electronic module such as a camera module and/or a battery module between the display module DM and the housing HAU.

The window WM may be on the display module DM. The window WM may cover a front surface of the display module DM and may protect the display module DM from an external impact and scratch. The window WM may be coupled to the display module DM through an adhesive layer ADL.

The window WM may include an optically transparent insulation material. For example, the window WM may include a glass film and/or a synthetic resin film as a base film. The window WM may further include a functional layer such as an anti-fingerprint layer, a phase control layer, and/or a hard coating layer on the base film.

A front surface of the window WM may correspond to a front surface of the display device DD. The front surface of the window WM may include a transmission region TA and a bezel region BZA.

The transmission region TA may be optically transparent. The transmission region TA may allow an image IM provided by the display module DM to pass therethrough, and a user may view the image IM through the transmission region TA. In this embodiment, the transmission region TA is illustrated in a quadrilateral shape, but the transmission region TA may have various suitable shapes and is not limited to any one embodiment.

The bezel region BZA may be adjacent to the transmission region TA. The shape of the transmission region TA may be defined substantially by the bezel region BZA. For example, the bezel region BZA may be provided outside the transmission region TA and surround the transmission region TA. However, this is illustrated as an example, and the bezel region BZA may be adjacent to only one side of the transmission region TA or be on a side surface of the display device DD and not on a front surface.

The bezel region BZA may have a lower light transmittance than the transmission region TA. The bezel region BZA may correspond to a region in which a material having a set or predetermined color is printed. The bezel region BZA may prevent or reduce transmission of light and thus may prevent or reduce visibility from the outside of components of the display module DM that overlap the bezel region BZA.

The display module DM may be between the window WM and the housing HAU. The display module DM may include an active region AA and a peripheral region NAA. The active region AA of the display module DM may be activated in response to an electrical signal and may overlap at least a portion of the transmission region TA. The active region AA may correspond to a display region AA-D (see FIG. 3) of a display panel DP (see FIG. 3) to be further described herein.

The peripheral region NAA of the display module DM may be adjacent to the active region AA. For example, the peripheral region NAA may surround the active region AA. However, the peripheral region NAA is not limited thereto, and may be defined as various suitable shapes. The peripheral region NAA may be a region in which a driving circuit, a signal line, a pad, and/or the like to drive an element within the active region AA are provided. The peripheral region NAA may correspond to a non-display region NAA-D (see FIG. 3) of the display panel DP (see FIG. 3) to be further described herein.

The peripheral region NAA may overlap at least a portion of the bezel region BZA. Visibility from the outside of the components provided in the peripheral region NAA may be prevented or reduced, by the bezel region BZA.

Referring to FIGS. 2 and 3, the display module DM may include the display panel DP. FIG. 3 illustrates, as an example, a plan view of the display panel DP included in the display module DM.

The display panel DP may generate an image IM in response to an electrical signal. The display panel DP according to an embodiment may be a light-emitting display panel, but is not particularly limited. For example, the display panel DP may be an organic light-emitting display panel, an inorganic light-emitting display panel, and/or a quantum dot light-emitting display panel. A light-emitting layer of an organic light-emitting display panel may include an organic light-emitting material, and a light-emitting layer of an inorganic light-emitting display panel may include an inorganic light-emitting material, and a light-emitting layer of a quantum dot light-emitting display panel may include quantum dots, quantum rods, and/or the like.

The display panel DP may include a base substrate BS, pixels PX, signal lines SL1-SLm, DL1-DLn, EL1-ELm, CSL1, CSL2, and PL electrically coupled to the pixels PX, a scan driver SDV, a data driver DDV, an emission driver EDV, and display pads D-PD.

The base substrate BS may provide, on a plane parallel (e.g., substantially parallel) to each of the first direction DR1 and the second direction DR2, a base surface on which elements and wires of the display panel DP are provided. The base substrate BS may include a display region AA-D and a non-display region NAA-D of the display panel DP.

The display region AA-D may be a region in which pixels PX are provided to display an image IM. The non-display region NAA-D may be a region which is adjacent to the display region AA-D and in which an image IM is not displayed. The scan driver SDV, the data driver DDV, the emission driver EDV, etc., for driving the pixels PX may be in the non-display region NAA-D. However, an embodiment of the present invention is not limited thereto, and to reduce the area of the non-display region NAA-D, at least one of the scan driver SDV, the data driver DDV, or the emission driver EDV may be in the display region AA-D.

Each of the pixels PX may include a pixel driving circuit composed of transistors (for example, a switching transistor, a driving transistor, and/or the like) and at least one capacitor, and an emission element electrically coupled to the pixel driving circuit. The pixels PX may emit light in response to electrical signals applied to the pixels PX and thus display an image in the display region AA-D.

The display module DM and the display panel DP may include a first region AR1, a second region AR2, and a bending region BA. The first region AR1, the bending region BA, and a second region AR2 may be provided in the second direction DR2. The first region AR1 may extend from one side of the bending region BA and the second region AR2 may extend from an other side of the bending region BA. The first region AR1 and the second region AR2 may be spaced apart from each other. The bending region BA may be between the first region AR1 and the second region AR2.

The display region AA-D of the display panel DP (or, the active region AA of the display module DM) may be defined in the first region AR1. In the first region AR1, a region that excludes the display region AA-D (or the active region AA) may be defined as the non-display region NAA-D (or the peripheral region NAA).

The bending region BA may extend from the first region AR1, and the second region AR2 may extend from the bending region BA in the direction opposed to (e.g., opposite to) the first region AR1. The bending region BA and the second region AR2 may be defined as the non-display region NAA-D (or the peripheral region NAA).

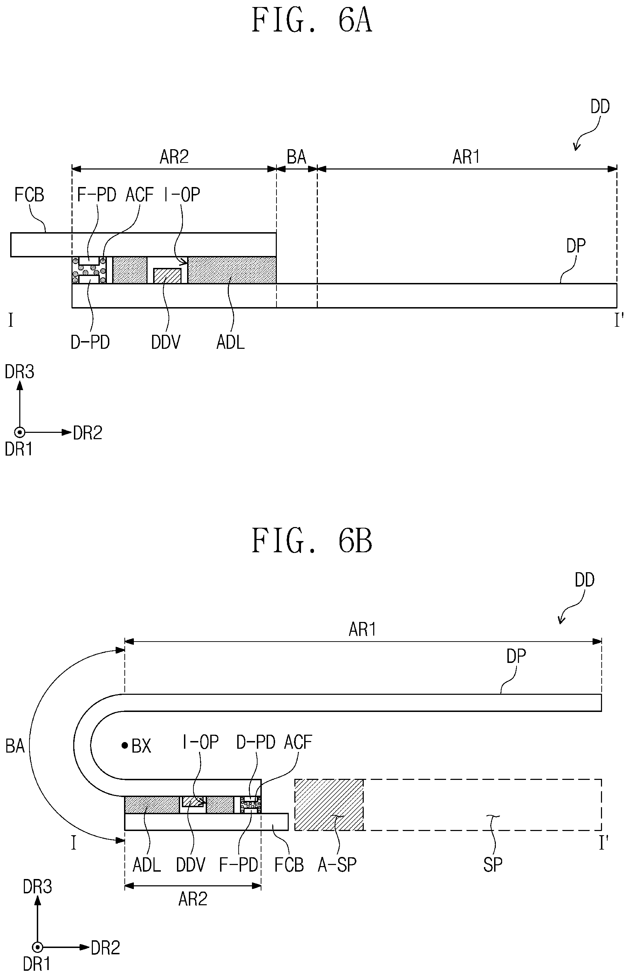

The bending region BA may be bent with respect to a bending axis BX (see FIG. 6B) parallel (e.g., substantially parallel) to the first direction DR1. For example, the bending region BA may be bent toward a rear surface of the first region AR1 of the display panel DP. Because the bending region BA is bent, on a plane, the second region AR2 extending from the other side of the bending region BA may overlap the first region AR1. For example, the second region AR2 may be on the rear surface corresponding to the first region AR1 of the display panel DP.

FIGS. 2 and 3 illustrate that the bending region BA and the first region AR1 have substantially the same width in the first direction DR1 parallel to the bending axis BX (see FIG. 6B), but embodiments of the present invention are not limited thereto. For example, the bending region BA may be smaller in width than the first region AR1 in the first direction DR1, and the bending region BA may be bent with ease.

Referring to FIG. 3, the signal lines SL1-SLm, DL1-DLn, EL1-ELm, CSL1, CSL2, and PL of the display panel DP may include scan lines SL1-SLm, data lines DL1-DLn, emission lines EL1-ELm, first and second control lines CSL1 and CSL2, and a power line PL. In embodiments, m and n indicate a natural number greater than or equal to 1.

Each of the pixels PX may be electrically coupled to corresponding scan lines, data lines, and emission lines among the scan lines SL1-SLm, data lines DL1-DLn, and emission lines EL1-ELm. Additional types (or kinds) of signal lines may be provided to the display panel DP depending on the configuration of a pixel driving circuit of the pixels PX.

The data lines DL1-DLn may be insulated (e.g., electrically insulated) from the scan lines SL1-SLm and the emission lines EL1-ELm, and on a plane, the data lines DL1-DLn may cross the scan lines SL1-SLm and the emission lines EL1-ELm. For example, the scan lines SL1-SLm may extend in the first direction DR1 and be electrically coupled to the scan driver SDV. The data lines DL1-DLn may extend in the second direction DR2 and be electrically coupled to the data driver DDV. The emission lines EL1-ELm may extend in the first direction DR1 and be electrically coupled to the emission driver EDV.

The power line PL may include a portion that extends in the first direction DR1 and a portion that extends in the second direction DR2. The portion of the power line PL that extends in the second direction DR2 may be on the non-display region NAA-D. The portion of the power line PL that extends in the first direction DR1 may be electrically coupled to the pixels PX and the portion of the power line PL that extends in the second direction DR2. The portion of the power line PL that extends in the first direction DR1 and the portion that extends in the second direction DR2 may be on different layers and coupled through a contact hole, or the portion of the power line PL that extends in the first direction DR1 and the portion that extends in the second direction DR2 may have an integral shape at the same layer.

A first control line CSL1 may be electrically coupled to the scan driver SDV. A second control line CSL2 may be electrically coupled to the emission driver EDV.

The data driver DDV may include a data driving circuit to drive the pixels PX. The data driver DDV may be provided as an integrated circuit chip defined as a driving chip and be mounted in the non-display region NAA-D of the display panel DP. For example, the data driver DDV may be mounted on the second region AR2 within the non-display region NAA-D. However, embodiments are not limited thereto, and the data driver DDV may be mounted on a circuit board FCB electrically coupled to the display panel DP. In embodiments, the data driving circuit of the data driver DDV and the transistors of the pixels PX may be formed through the same forming process. Hereinafter, an embodiment in which the data driver DDV is provided as a driving chip will be mainly described, and a driving chip DDV and the data driver DDV are indicated by the same reference symbol.

The scan driver SDV may generate scan signals in response to a scan control signal. The scan signals may be applied to the pixels PX through the scan lines SL1-SLm. The driving chip DDV may generate data voltages corresponding to image signals in response to a data control signal. The data voltages may be applied to the pixels PX through the data lines DL1-DLn. The emission driver EDV may generate emission signals in response to an emission control signal. The emission signals may be applied to the pixels PX through the emission lines EL1-ELm.

The pixels PX may receive data voltages in response to the scan signals. The pixels PX may generate an image IM within the display region AA-D by emitting light having a brightness corresponding to the data voltages in response to the emission signals. An emission time of the pixels PX may be controlled by the emission signals.

The display pads D-PD may be adjacent to a lower end of the second region AR2. The display pads D-PD may be provided more adjacent to a lower end of the display panel DP than the driving chip DDV. The display pads D-PD may be provided along the first direction DR1. The display pads D-PD may be spaced apart from each other in the first direction DR1. A region in which the display pads D-PD are on the second region AR2 may be defined as a panel pad region D-A.

The display pads D-PD may be electrically coupled to the pixels PX. Each of the display pads D-PD may be coupled to a corresponding signal line among the signal lines SL1-SLm, DL1-DLn, EL1-ELm, CSL1, CSL2, and PL. For example, each of the display pads D-PD may be electrically coupled to the power line PL, the first control line CSL1, the second control line CSL2, and the data lines DL1-DLn. The signal lines (for example, the power line PL, the first control line CSL1, the second control line CSL2, and the data lines DL1-DLn) coupled to the display pads D-PD and the driving chip DDV may extend from the first region AR1 toward the second region AR2 via the bending region BA.

The display pads D-PD may be portions electrically coupled to the circuit board FCB which provides signals to control operations of the scan driver SDV, the driving chip DDV, and the emission driver EDV of the display panel DP.

Referring to FIGS. 2 and 3, the circuit board FCB may be on the non-display region NAA-D. The circuit board FCB may be on the second region AR2 of the non-display region NAA-D. The circuit board FCB may be on the display panel DP and electrically coupled to the display pads D-PD. The circuit board FCB may generate an electrical signal and provide the electrical signal to the display panel DP, or receive a signal generated from the display panel DP and process the signal. The circuit board FCB may be coupled to a main circuit board involved in driving various suitable electronic modules of the display device DD.

The circuit board FCB may further include a base film CB, connection pads F-PD, and a connector CNT. The base film CB may be a flexible film having flexibility, and the circuit board FCB may be a flexible circuit board which is flexible. However, embodiments of the present invention are not necessarily limited thereto.

The base film CB may include a first surface U-F and a second surface B-F. The second surface B-F may face a front surface of the second region AR2 of the display panel DP. The first surface U-F may be opposed to (e.g., opposite to) the second surface B-F and exposed toward the outside in the third direction DR3 on a front surface of the display panel DP. The first surface U-F may correspond to a front surface of the base film CB, and the second surface B-F may correspond to a rear surface of the base film CB.

The connection pads F-PD may be on the second surface B-F of the base film CB. The connection pads F-PD may be provided along the first direction DR1. The connection pads F-PD may be spaced apart from each other in the first direction DR1. A region in which the connection pads F-PD are on the base film CB may be defined as a board pad region F-A. The connection pads F-PD may overlap the display pads D-PD respectively. The connection pads F-PD may be electrically coupled to the display pads D-PD.

The connector CNT may be electrically coupled to an electronic module. The connector CNT may be a connection terminal coupled to an electronic module. The display module DM may be electrically coupled to an electronic module through the circuit board FCB including the connector CNT.

FIGS. 2 and 3 illustrate, as an example, that on a plane, the connector CNT is on a protruding portion of the circuit board FCB. However, the arrangement position of the connector CNT is not limited to what is illustrated.

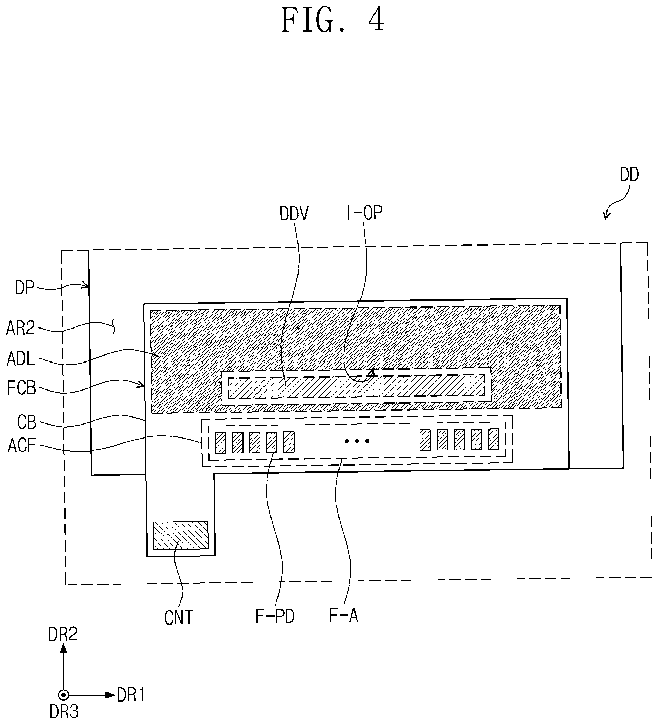

FIG. 4 is an enlarged plan view illustrating a portion of the display panel DP and the circuit board FCB illustrated in FIG. 3.

As an example, in FIG. 4, the driving chip DDV, the adhesive layer ADL, and the conductive adhesive layer ACF are illustrated with dotted lines.

Referring to FIGS. 2 and 4, the adhesive layer ADL may be between the circuit board FCB and the display module DM. The adhesive layer ADL may have a rectangular shape having long sides that extend in the first direction DR1 and short sides that extend in the second direction DR2. However, the shape of the adhesive layer ADL is not limited thereto.

The adhesive layer ADL may be on the front surface of the second region AR2. A rear surface of the adhesive layer ADL may have adhesiveness. The rear surface of the adhesive layer ADL may be attached to the front surface of the second region AR2.

An opening I-OP penetrating the adhesive layer ADL may be defined in the adhesive layer ADL. The opening I-OP may overlap the driving chip DDV on a plane. The driving chip DDV may be provided in the opening I-OP. An area of the opening I-OP may be substantially equal to or greater than an area of the driving chip DDV.

When seen on a plane (e.g., in a plan view), the driving chip DDV may be exposed to the outside from the adhesive layer ADL through the opening I-OP. When seen on a plane (e.g., in a plan view), the driving chip DDV may be surrounded by the adhesive layer ADL.

In embodiments, a thickness of the adhesive layer ADL may be greater than a thickness of the driving chip DDV. The thickness of the adhesive layer ADL and the thickness of the driving chip DDV will be described in more detail with respect to FIGS. 6A and 6B.

A front surface of the adhesive layer ADL may have adhesiveness. The front surface of the adhesive layer ADL may be attached to a rear surface of the circuit board FCB. The circuit board FCB and the second region AR2 may be bonded to each other through the adhesive layer ADL.

Because the rear surface of the adhesive layer ADL and the front surface of the second region AR2, and the front surface of the adhesive layer ADL and the rear surface of the circuit board FCB are adhered to each other, it is possible to prevent or reduce introduction of moisture into the opening I-OP in which the driving chip DDV is provided.

When seen on a plane (e.g., in a plan view), an area of the circuit board FCB may be greater than an area of the adhesive layer ADL. The adhesive layer ADL may not overlap the board pad region F-A of the circuit board FCB.

The conductive adhesive layer ACF may be between the circuit board FCB and the display module DM. The conductive adhesive layer ACF and the adhesive layer ADL may be provided in the second direction DR2. The conductive adhesive layer ACF may be more adjacent to a border of the display panel DP and a border of the circuit board FCB than the adhesive layer ADL. An area of the conductive adhesive layer ACF may be smaller than an area of the adhesive layer ADL.

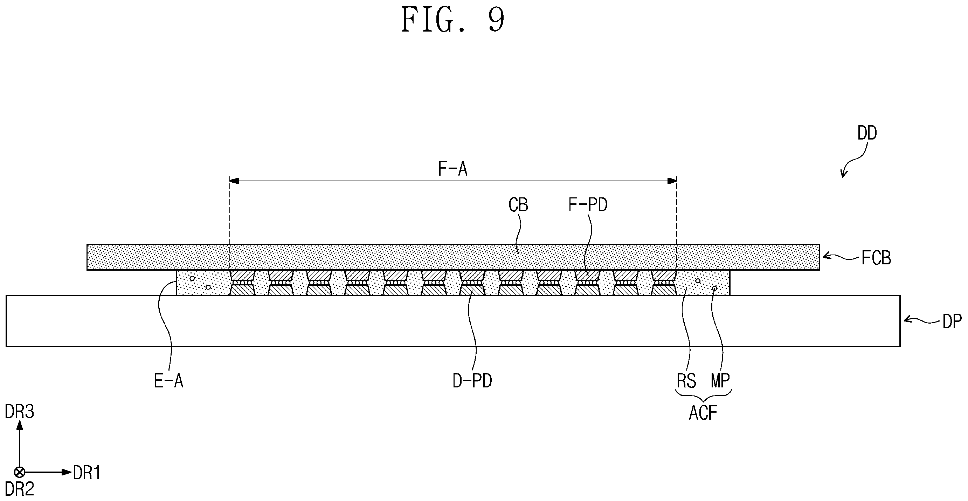

When seen on a plane (e.g., in a plan view), the conductive adhesive layer ACF may be provided corresponding to the panel pad region D-A and the board pad region F-A. The conductive adhesive layer ACF may be between the display pads D-PD and the connection pads F-PD. The display pads D-PD and the connection pads F-PD may be electrically coupled to each other through the conductive adhesive layer ACF. An electrical connection between the display pads D-PD and the connection pads F-PD will be described in more detail with respect to FIG. 9.

The conductive adhesive layer ACF may be provided in a shape having a length that extends along the first direction DR1 to overlap the connection pads F-PD provided along the first direction DR1. The length of the conductive adhesive layer ACF in the first direction DR1 may be provided greater than a length of the board pad region F-A in the first direction DR1. For example, the conductive adhesive layer ACF may extend further than the outside of the board pad region F-A. Accordingly, on a plane (e.g., in a plan view), the conductive adhesive layer ACF may completely cover the connection pads F-PD. It is possible to prevent or reduce non-connection of some pads caused by process errors during bonding of the connection pads F-PD and the display pads D-PD through the conductive adhesive layer ACF, and the connection reliability between the display panel DP and the circuit board FCB may be improved.

Referring to FIGS. 2 and 3, the window WM and the housing HAU may be coupled together to form an exterior of the display device DD. The display module DM may be accommodated in the internal space formed by coupling the window WM and the housing HAU. As the bending region BA of the display module DM is bent, the circuit board FCB on the second region AR2 may be provided on the rear surface of the first region AR1 and accommodated inside the housing HAU.

The housing HAU may include a material having relatively high rigidity. For example, the housing HAU may include a frame and/or a plate containing glass, plastic, or metal, or composed of a combination thereof. The housing HAU may absorb impact applied from the outside or prevent or reduce infiltration of foreign matter/moisture from the outside, and thus protect the display module DM accommodated in the housing HAU.

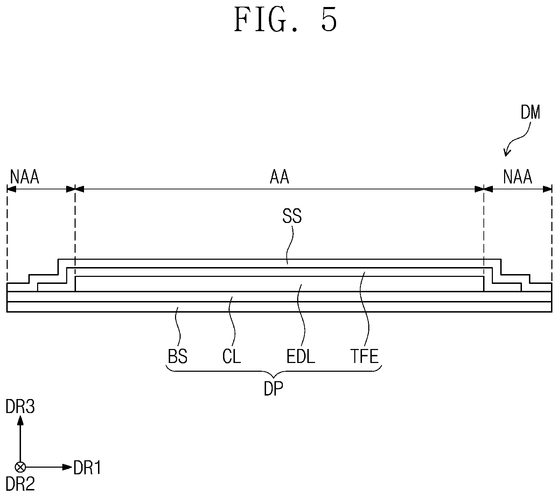

FIG. 5 is a cross-sectional view of the display module DM according to an embodiment of the present invention.

Referring to FIG. 5, the display module DM may include the display panel DP and a sensor layer SS. The display panel DP may include the base substrate BS, a circuit layer CL, a display element layer EDL, and an encapsulation layer TFE.

The base substrate BS may provide a base surface on which the circuit layer CL is provided. The base substrate BS may be a rigid substrate or a flexible substrate which is bendable, foldable, rollable, and/or the like. The base substrate BS may be a glass substrate, a metal substrate, a polymer substrate, and/or the like. Embodiments of the present invention are not limited thereto, and the base substrate BS may include an inorganic layer, a synthetic resin layer, or a composite material layer (e.g., including an inorganic layer and a synthetic resin layer).

The base substrate BS may have a multi-layered structure. For example, the base substrate BS may include synthetic resin layers and a multi-layered or a single-layered inorganic layer between the synthetic resin layers. The synthetic resin layer may include an acrylate-based resin, a methacrylate-based resin, a polyisoprene, a vinyl-based resin, an epoxy-based resin, a urethane-based resin, a cellulose-based resin, a siloxane-based resin, a polyamide-based resin, a perylene-based resin, and/or the like, but materials of the synthetic resin layer are not limited thereto.

The circuit layer CL may be on the base substrate BS. The circuit layer CL may include at least one selected from among an insulation layer (e.g., an electrical insulation layer), a semiconductor pattern, and a conductive pattern (e.g., an electrically conductive pattern). The insulation layer, the semiconductor pattern, and the conductive pattern of the circuit layer CL may be formed by forming an insulation layer (e.g., an electrical insulation layer), a semiconductor layer, and a conductive layer (e.g., an electrically conductive layer) through coating, deposition, and/or the like, and then patterning the insulation layer, the semiconductor layer, and the conductive layer through a plurality of photolithography processes. The insulation layer, the semiconductor layer, and the conductive layer included in the circuit layer CL may form driving elements such as transistors, signal lines, and panel pads in the circuit layer CL.

The display element layer EDL may be on the circuit layer CL. The display element layer EDL may include emission elements provided in the active region AA. The emission elements of the display element layer EDL may be electrically coupled to the driving elements of the circuit layer CL and generate light in the active region AA in response to signals provided by the driving elements.

The encapsulation layer TFE may be on the display element layer EDL and seal the emission elements. The encapsulation layer TFE may include at least one thin film to improve the optical efficiency of the display element layer EDL and/or to protect the display element layer EDL. The encapsulation layer TFE may include at least one of an inorganic film or an organic film.

The sensor layer SS may be on the display panel DP. The sensor layer SS may be formed on the display panel DP through a continuous (e.g., a substantially continuous) process. In embodiments, the sensor layer SS may be directly on the display panel DP without an additional adhesive layer ADL. However, embodiments of the present invention are not necessarily limited thereto, and the sensor layer SS may be coupled onto the display panel DP through an adhesive layer ADL.

The sensor layer SS may include at least one of an input sensor, an antenna sensor, or a fingerprint sensor. For example, the sensor layer SS may include an input sensor, and the input senor may sense an external input and provide an input signal, which includes information about the external input, so that the display panel DP may generate an image corresponding to the external input. The input sensor may be driven by various suitable methods such as a capacitive method, a resistive film method, an infrared method, a sonic wave method, and/or a pressure method, but embodiments of the present invention are not limited to any one method.

Components of the display module DM are not limited to what is illustrated, and a protection member on a lower portion of the display panel DP and/or an anti-reflection layer on an upper portion of the display panel DP may be further included.

In an embodiment, the protection member may be on a rear surface of the display panel DP and protect the display panel DP from an external impact. The protection member may include layers such as a cushion layer which absorbs impact, a heat dissipation layer which prevents or reduces transfer of heat to the display panel DP, and/or a shielding layer which blocks or reduces reflection of light and/or electromagnetic waves.

In an embodiment, the anti-reflection layer may be on the sensor layer SS. The anti-reflection layer may be on the sensor layer SS without an adhesive layer ADL through a continuous (e.g., substantially continuous) process, or without being limited thereto, the anti-reflection layer may be coupled onto the sensor layer SS through an adhesive layer. Also, a stacked position of the anti-reflection layer may be between the display panel DP and the sensor layer SS.

The anti-reflection layer may include various suitable examples to reduce reflectance of external light incident from the outside of the display device DD (see FIG. 1). For example, the anti-reflection layer may include a polarization film which includes a retarder and/or a polarizer, multi-layered reflection layers which destructively interferes with reflected light, and/or color filters which are provided corresponding to an arrangement of pixels PX (see FIG. 3) and emission color.

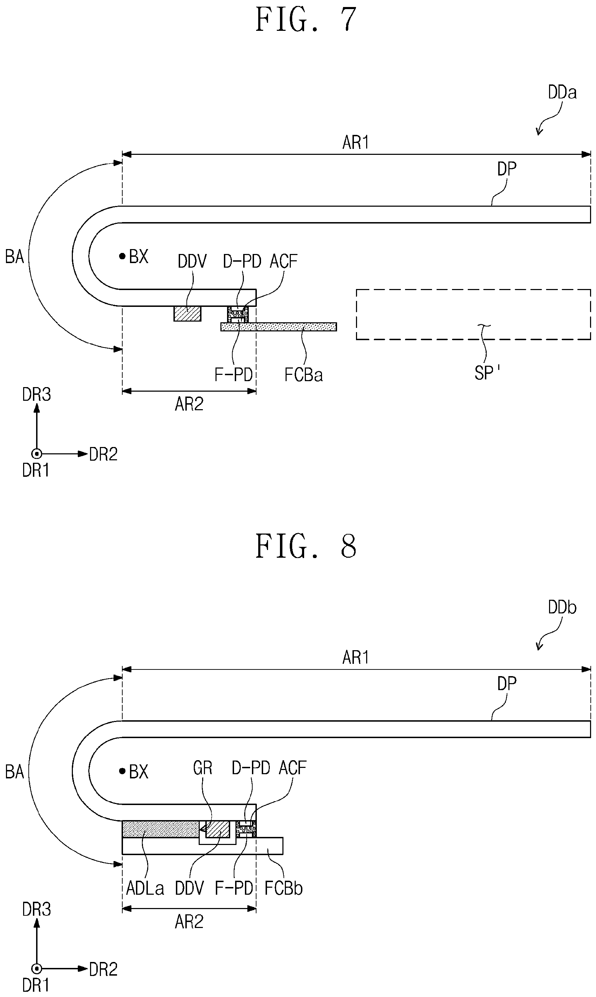

FIG. 6A is a cross-sectional view of the display panel DP, the circuit board FCB, the adhesive layer ADL, and the conductive adhesive layer ACF taken along line I-I' illustrated in FIG. 3. FIG. 6B is a cross-sectional view of the bending region BA illustrated in FIG. 6A in a bent state. FIG. 7 is a cross-sectional view of a display device DDa according to a Comparative Example. FIG. 8 is a cross-sectional view of a display device DDb according to another Comparative Example.

As an example, the display panel DP is schematically illustrated as a single layer.

Among components illustrated in FIGS. 6A to 8, the descriptions of the components that are the same as the components explained with reference to the drawings may not be repeated or may be explained briefly.

Referring to FIG. 6A, the driving chip DDV and the display pad D-PD may be on the second region AR2. The display pad D-PD may be adjacent to one side of the second region AR2 spaced apart from the bending region BA.

The adhesive layer ADL may be on the front surface of the second region AR2. The rear surface of the adhesive layer ADL and the rear surface of the driving chip DDV may be on the same plane. A thickness of the adhesive layer ADL may be greater than a thickness of the driving chip DDV. When the bending region BA is unfolded flat, a height of a top surface of the adhesive layer ADL may be greater than a height of a top surface of the driving chip DDV. That means that the top surface of the adhesive layer ADL may be positioned higher or at a higher level than the top surface of the driving chip DDV.

The circuit board FCB may be on the second region AR2. The circuit board FCB may be on the front surface of the adhesive layer ADL. The circuit board FCB may overlap the opening I-OP and the driving chip DDV. Because the thickness of the adhesive layer ADL is greater than the thickness of the driving chip DDV, the driving chip DDV may not be in contact with the circuit board FCB. The adhesive layer ADL and the circuit board FCB may surround the driving chip DDV.

The conductive adhesive layer ACF may be between the connection pads F-PD and the display pads D-PD. The connection pads F-PD may be electrically coupled to the display pads D-PD through the conductive adhesive layer ACF.

Referring to FIG. 6B, the bending region BA of the display panel DP may be bent with respect to the bending axis BX that extends in the first direction DR1. The bending region BA may be bent to have a curvature. Because the bending region BA is bent, the first region AR1 and the second region AR2 may overlap in the third direction DR3.

A space SP may be present on the rear surface of the first region AR1 of the display panel DP. The space SP, and the second region AR2, the adhesive layer ADL and the circuit board FCB may be formed on the same plane. Functional electronic modules such as a battery module, a camera module, and a sensor module, which constitute the display device DD, may be provided in the space SP.
One side, spaced apart from the bending region BA, among two sides of the circuit board FCB substantially opposed to each other (e.g., substantially opposite to each other) in the second direction DR2 may protrude further in the second direction DR2 than one side of the second region AR2. The size of the space SP may suitably vary depending on a distance from the one side of the second region AR2 to the one side of the circuit board FCB.

In an embodiment, one side adjacent to the adhesive layer ADL among two sides of the circuit board FCB opposed to each other in a second direction DR2 that crosses the first direction DR1 is further inside the base substrate BS than the driving chip DDV.

Referring to FIGS. 6B and 7, among two sides of a circuit board FCBa according to Comparative Example opposed to (e.g., opposite to) each other in the second direction DR2, other side adjacent to a driving chip DDV may be provided adjacent to a display pad D-PD and one side of a second region AR2. The circuit board FCBa according to Comparative Example may not overlap the driving chip DDV. The circuit board FCBa according to the Comparative Example may be spaced apart from the driving chip DDV. For example, the other side of the circuit board FCBa according to Comparative Example may be between the display pad D-PD and the driving chip DDV.

A minimum area may be required or utilized in which wires or elements may be provided in the circuit board FCBa. Thus, because the other side of the circuit board FCBa may be provided more adjacent to the one side of the second region AR2 than the driving chip DDV, a distance from the one side of the second region AR2 to one side of the circuit board FCBa according to Comparative Example may extend further than the circuit board FCB according to Example in FIG. 6B.

Based on a circuit board with the same area, a space occupied by the circuit board FCB according to Example in FIG. 6B may be smaller than a space occupied by the circuit board FCBa according to the Comparative Example in FIG. 7. For example, a space SP' in which an electronic module is to be provided may be reduced as much as a region the circuit board FCBa is on a rear surface of a first region AR1.

Because the opening I-OP is defined in the adhesive layer ADL having a thickness greater than that of the driving chip DDV, a height of the top surface of the adhesive layer ADL may be smaller than a height of the top surface of the driving chip DDV when the bending region BA is bent. That means that the top surface of the adhesive layer ADL may be positioned lower or at a lower level than the top surface of the driving chip DDV. The circuit board FCB may be extended to overlap the driving chip DDV and be on the adhesive layer ADL. The circuit board FCB may be provided flatly on the top surface of the adhesive layer ADL. The adhesive layer ADL and the circuit board FCB may surround the driving chip DDV.

Accordingly, the circuit board FCB may be provided so as to minimize or reduce a distance from a lower end of the second region AR2 to other end of the circuit board FCB, and thus an additional space A-SP may be secured compared to the display device DDa according to Comparative Example.

Because the additional space A-SP in which an electronic module may be provided is formed in the display device DD, an arrangement limitation of the electronic module may be reduced, and an electronic module having a relatively big volume or area may be accommodated without increasing the size of the display device DD.

Referring to FIG. 8, to provide a circuit board FCBb on an adhesive layer ADLa flatly, a groove GR may be defined in a rear surface of the circuit board FCBb facing a driving chip DDV. In embodiments, wires inside the circuit board FCBb may be designed such that the wires are provided bypassing the groove GR. The wires inside the circuit board FCBb may be provided complicatedly (e.g., in a complicated manner or to have a complicated pattern).

Referring to FIG. 6B, according to an embodiment of the present invention, because the adhesive layer ADL has a thickness greater than that of the driving chip DDV, a groove GR (see FIG. 8) may not be defined in a portion of the circuit board FCB that overlaps the driving chip DDV. Accordingly, an arrangement of the wires may be relatively simple. Thus, manufacturing the display device DD may be easy.

FIG. 9 is a cross-sectional view of the display panel DP and the circuit board FCB, taken along line II-II' illustrated in FIG. 3.

Among components illustrated in FIG. 9, the descriptions of the components that are the same as the components explained with reference to the drawings may not be repeated or may be explained briefly.

The conductive adhesive layer ACF may be provided between the connection pads F-PD of the circuit board FCB and the display pads D-PD of the display panel DP. The conductive adhesive layer ACF may be on the second surface B-F (see FIG. 2) of the base film CB and the connection pads F-PD.

The conductive adhesive layer ACF may have both conductivity (e.g., electrical conductivity) and adhesiveness. Accordingly, the conductive adhesive layer ACF may couple the circuit board FCB and the display panel DP physically and electrically. For example, the conductive adhesive layer ACF may include an anisotropic conductive adhesive film (e.g., an anisotropic electrically conductive adhesive film). The conductive adhesive layer ACF may include an adhesive resin RS and conductive particles MP (e.g., electrically conductive particles MP).

The adhesive resin RS may overlap the display pads D-PD and the connection pads F-PD. The adhesive resin RS may overlap the board pad region F-A and may be provided to extend more toward the outside of the board pad region F-A in the first direction DR1. An end of the adhesive resin RS may correspond to an end E-A of the conductive adhesive layer ACF.

The display pads D-PD and the connection pads F-PD may be physically coupled to each other through the adhesive resin RS. Because the adhesive resin RS is provided to extend further than the board pad region F-A, the display panel DP and the circuit board FCB may be coupled stably.

The adhesive resin RS may include a polymer material. For example, the adhesive resin RS may include at least one of an acryl-based polymer, a silicon-based polymer, a urethane-based polymer, or an imide-based polymer. The adhesive resin RS may be formed by heat curing and/or photocuring a polymer resin.

The conductive particles MP may be dispersed in the adhesive resin RS. The conductive particles MP may be aligned between the display pads D-PD and the connection pads F-PD to correspond to each other inside the adhesive resin RS. During bonding of the circuit board FCB to the display panel DP, the conductive particles MP may have an anisotropy through pressing so that current flows in a pressing direction. For example, a current direction in which current (e.g., electric current) flows through the conductive particles MP may be parallel (e.g., substantially parallel) to the pressing direction, and current (e.g., electric current) may not flow in a direction crossing the pressing direction. Accordingly, the display pads D-PD and the connection pads F-PD may be electrically coupled through the conductive particles MP between the display pads D-PD and the connection pads F-PD. Also, occurrence of short-circuiting between the display pads D-PD adjacent to each other in the first direction DR1 and/or a short-circuiting between the connection pads F-PD adjacent to each other in the first direction DR1 may be prevented or reduced.

The conductive particles MP may be metal particles and/or alloy particles in which a plurality of metals are combined. For example, the conductive particles MP may be metal and/or metal alloy particles including at least one of silver, copper, bismuth, zinc, indium, tin, nickel, cobalt, chrome, or iron. In embodiments, the conductive particles MP may each have a core portion which is formed of polymer resin, and/or the like, and a coating layer which is formed of a conductive material (e.g., an electrically conductive material) and covers the core portion.

The conductive adhesive layer ACF may be provided in a region in which the display pads D-PD and the connection pads F-PD electrically coupled through the conductive adhesive layer ACF are provided. For example, the conductive adhesive layer ACF may correspond to the panel pad region D-A and the board pad region F-A. The conductive adhesive layer ACF may contact each of the display pads D-PD and each of the connection pads F-PD and electrically couple the display pads D-PD and the connection pads F-PD.

The conductive adhesive layer ACF may be provided in a shape having a length that extends along the first direction DR1 to overlap the connection pads F-PD provided along the first direction DR1. The length of the conductive adhesive layer ACF in the first direction DR1 may be greater than a length of the board pad region F-A in the first direction DR1. For example, the conductive adhesive layer ACF may extend further than the outside of the board pad region F-A. Accordingly, on a plane (e.g., in a plan view), the conductive adhesive layer ACF may completely cover the connection pads F-PD. It is possible to prevent or reduce non-connection of some pads caused by process errors during bonding of the connection pads F-PD and the display pads D-PD through the conductive adhesive layer ACF, and the connection reliability between the display panel DP and the circuit board FCB may thus be improved.

According to an embodiment of the present invention, a driving chip DDV of a display panel DP may be provided inside an opening I-OP of an adhesive layer ADL that has a greater thickness than that of the driving chip DDV. Accordingly, an area of a circuit board FCB that protrudes further than a border of the display panel DP is reduced, and thus space SP occupied by the circuit board TCB may be reduced. This makes it possible to secure a space SP in which an electronic module is provided.

In the above, description has been made with reference to example embodiments of the present invention, but those skilled in the art or those of ordinary skill in the relevant technical field may understand that various suitable modifications and changes may be made to embodiments of the present invention without departing from the scope of the present invention as described in the appended claims..

## Claims

1. A display device (DD) comprising:
a display panel (DP);
a circuit board (FCB) electrically coupled to the display panel (DP); and
an adhesive layer (ADL) between the display panel (DP) and the circuit board (FCB),
wherein the display panel (DP) comprises:
a base substrate (BS) comprising a display region (AA-D) and a non-display region (NAA-D) adjacent to the display region (AA-D),
a driving chip (DDV) mounted on the non-display region (NAA-D), and
a plurality of display pads (D-PD) on the non-display region (NAA-D), and electrically coupled to the driving chip (DDV) and the circuit board (FCB), and
the driving chip (DDV) is provided in an opening (I-OP) defined in the adhesive layer (ADL), and a thickness of the driving chip (DDV) is smaller than a thickness of the adhesive layer (ADL).

2. The display device (DD) of claim 1, wherein a bending region (BA) bent with respect to a bending axis (BX) that extends in a first direction (DR1) is defined in the non-display region (NAA-D).

3. A display device (DD) comprising:
a display panel (DP);
an adhesive layer (ADL) on a top surface of the display panel (DP), and having an opening (I-OP) defined therein; and
a circuit board (FCB) on a top surface of the adhesive layer (ADL) and electrically coupled to the display panel (DP),
wherein the display panel (DP) comprises:
a base substrate (BS) comprising a display region (AA-D) and a non-display region (NAA-D) that is adjacent to the display region (AA-D) and that is bent with respect to a bending axis (BX) that extends in a first direction (DR1), and
a driving chip (DDV) mounted on the non-display region (NAA-D), and provided in the opening (I-OP),
a thickness of the adhesive layer (ADL) and a thickness of the driving chip (DDV) are different from each other, and when seen on a plane, the driving chip (DDV) does not overlap the adhesive layer (ADL).

4. The display device (DD) of claim 3, wherein the thickness of the adhesive layer (ADL) is greater than the thickness of the driving chip (DDV).

5. The display device (DD) of claim 3 or 4, wherein the display panel (DP) further comprises a plurality of display pads (D-PD) on the non-display region (NAA-D), and electrically coupled to the driving chip (DDV) and the circuit board (FCB).

6. The display device (DD) of one of claims 2 to 5, wherein when the bending region (BA) or the non-display region (NAA-D) is bent, a top surface of the adhesive layer (ADL) that faces the circuit board (FCB) is positioned lower than a top surface of the driving chip (DDV) that faces the circuit board (FCB).

7. The display device (DD) of at least one of claims 1 to 6, wherein the circuit board (FCB) overlaps the opening (I-OP) and the driving chip (DDV), especially wherein one side adjacent to the adhesive layer (ADL) among two sides of the circuit board (FCB) opposed to each other in a second direction (DR2) that crosses the first direction (DR1) is further inside the base substrate (BS) than the driving chip (DDV).

8. The display device (DD) of claim 1 or 2 and 7, wherein the circuit board (FCB) is on a front surface of the adhesive layer (ADL), and
the driving chip (DDV) is not in contact with the circuit board (FCB).

9. The display device (DD) of at least one of claims 1 to 8, wherein when seen on a plane, an area of the circuit board (FCB) is greater than an area of the adhesive layer (ADL).

10. The display device (DD) of at least one of claims 1, 2 or 5 to 9, wherein the circuit board (FCB) further comprises a plurality of connection pads (F-PD) that overlap the display pads (D-PD), and
each of the connection pads is (F-PD) electrically coupled to a corresponding display pad (D-PD) among the display pads (D-PD).

11. The display device (DD) of claim 10, wherein the adhesive layer (ADL) does not overlap the connection pads (F-PD) and the display pads (D-PD).

12. The display device (DD) of claim 10 or 11, further comprising a conductive adhesive layer (ACF) between the connection pads (F-PD) and the display pads (D-PD).

13. The display device (DD) of claim 10 or 11, further comprising a conductive adhesive layer (ACF) between the display panel (DP) and the circuit board (FCB), and adjacent to the adhesive layer (ADL), and
wherein the connection pads (F-PD) and the display pads (D-PD) are electrically coupled to each other by the conductive adhesive layer (ACF), especially wherein the conductive adhesive layer (ACF) is provided outside the adhesive layer (ADL).

14. The display device (DD) of at least one of claims 1 to 13, wherein a bottom surface of the adhesive layer (ADL) that faces the display panel (DP), and a bottom surface of the driving chip (DDV) that faces the display panel (DP) are on the same plane.

15. An electronic device comprising:
a display device (DD) according to at least one of claims 1 to 14.
